# EUROPÄISCHE PATENTANMELDUNG

(11) **EP 1 191 682 A2**
(43) Veröffentlichungstag der Anmeldung: **27.03.2002**
(21) Anmeldenummer: 01121846.8
(22) Anmeldetag: 11.09.2001
(51) Int. Cl.: H03D 7/00

(54) **System und Verfahren zur Datenübertragung**

(30) Priorität: 20.09.2000 DE 10046586
(71) Anmelder: Infineon Technologies AG, 81669 München (DE)
(72) Erfinder: Hammes, Markus, Dr., 47178 Duisburg (DE); Van Waasen, Stefan, Dr., 47178 Duisburg (DE)
(74) Vertreter: Epping Hermann & Fischer

(57) **Zusammenfassung**

Es ist ein System und ein Verfahren zur Datenübertragung, insbesondere für den Mobilfunk, angegeben, bei dem ein erster Transceiver (TR1) in einem ersten Zeitabschnitt sendet und ein zweiter Transceiver (TR2) empfängt und in einem zweiten Zeitabschnitt umgekehrt. Die Übertragung ist dabei durch eine Zeitduplex-Komponente gekennzeichnet. Während ein Lokaloszillator (LO1) des ersten Transceivers (TR1) bei Senden und Empfangen auf eine erste Trägerfrequenz (FC1) abgestimmt ist, ist der Lokaloszillator (LO2) des zweiten Transceivers (TR2) bei Senden und Empfangen auf eine zweite Trägerfrequenz (FC2) abgestimmt, welche sich von der ersten Trägerfrequenz (FC1) um einen Betrag einer Frequenzabweichung (ΔF) unterscheidet. Diese Einstellbarkeit des Empfangsseitenbands ermöglicht die Verwendung von Standard-PLL.

## Beschreibung

Die Erfindung betrifft ein System und ein Verfahren zur Datenübertragung, insbesondere im Mobilfunk, mit einer Zeitduplex-Komponente.

Moderne digitale Mobilfunksysteme sind ausschließlich vollduplexfähige Systeme. Bei Vollduplex-Systemen, d.h. bei bidirektionaler Kommunikation, kann gleichzeitig gesendet und empfangen werden. Dabei wird auch dann von vollduplexfähigen Systemen gesprochen, wenn Senden und Empfangen nicht gleichzeitig erfolgen, das Umschalten zwischen den Übertragungsrichtungen aber vom Teilnehmer unbemerkt erfolgt.

Man unterscheidet zwei grundlegende Duplexverfahren. Bei Frequenzduplex (FDD, Frequency Division Duplex) erfolgen Senden und Empfangen in verschiedenen, getrennten Frequenzbändern. Beim Zeitduplex (TDD, Time Division Duplex) werden die Übertragungsrichtungen in verschiedenen Zeitlagen oder Zeitschlitzen getrennt.

Um eine vereinfachte Transceiver-Struktur zu bilden, welche einfach integrierbar ist, werden bei bekannten Mobilfunk-Standards wie GSM, TDD- und FDD-Verfahren gemischt eingesetzt.

In dem Aufsatz "Architekturen für ein DECT-Sende- und Empfangsteil: Ein Vergleich", S. Atkinson, B. Wüppermann, ntz Band 46 (1993) Heft 10, Seiten 754 bis 757 sind homodyne und heterodyne Transceiver-Architekturen beschrieben.

Wenn beispielsweise Senden und Empfangen nicht in verschiedenen Frequenzbändern, d.h. nicht durch eine Duplexfrequenz voneinander beabstandet, erfolgen, so kann bei bestimmten Transceiver-Strukturen, beispielsweise bei homodynem Senden und heterodynem Empfangen, das Problem auftreten, daß ein Lokaloszillator, welcher sowohl für einen Sende- als auch für einen Empfangszweig des Transceivers verwendet wird, für Senden und Empfangen jeweils auf eine andere Frequenz einschwingen muß. Das bedeutet, daß die PLL (Phasenregelkreis) des Lokaloszillators, obwohl der physikalische Kanal zwischen Senden und Empfangen nicht gewechselt wird, trotzdem jeweils schnell auf eine neue Frequenz einschwingen muß. Damit ist der Nachteil verbunden, daß die übertragbare Netto-Datenrate gegenüber der Bruttodatenrate stark reduziert wird.

Zur Lösung des Problems könnte eine schnelle PLL (Fast Hopping-PLL) verwendet werden. Die Integration derartiger, schneller Regler ist zum einen sehr aufwendig, zum anderen verbleibt dennoch eine Reduzierung der Netto-Datenrate.

Aufgabe der vorliegenden Erfindung ist es, ein System und ein Verfahren zur Datenübertragung anzugeben, welches die Verwendung von Standard-PLLs ermöglicht.

Erfindungsgemäß wird die Aufgabe bezüglich des Systems gelöst von einem System zur Datenübertragung, insbesondere im Mobilfunk, mit
- einem ersten Transceiver mit einem Sendezweig zum Senden in einem ersten Zeitabschnitt und einem Empfangszweig zum Empfangen in einem zweiten Zeitabschnitt,
- einem zweiten Transceiver mit einem Sendezweig zum Senden in dem zweiten Zeitabschnitt und einem Empfangszweig zum Empfangen in dem ersten Zeitabschnitt,
- einem ersten Lokaloszillator im ersten Transceiver, der an dessen Sendezweig und an den Empfangszweig zur Bereitstellung eines ersten Lokaloszillator-Signals mit einer ersten Trägerfrequenz angeschlossen ist, wobei die erste Trägerfrequenz für Senden und Empfangen gleich ist,
- einem zweiten Lokaloszillator im zweiten Transceiver, der an dessen Sende- und Empfangszweig zur Bereitstellung eines zweiten Lokaloszillator-Signals mit einer zweiten Trägerfrequenz angeschlossen ist, wobei die zweite Trägerfrequenz für Senden und Empfangen gleich ist und sich von der ersten Trägerfrequenz um einen Betrag einer Frequenzabweichung unterscheidet, wobei in den Empfangszweigen je ein Polyphasen-Receiver vorgesehen ist mit je einem IQ-Mischer, dem ein Empfangssignal und das erste bzw. zweite Lokaloszillator-Signal eingangsseitig zuführbar sind und an dessen Ausgang je ein komplexes Bandpaß-Filter angeschlossen ist, mit einer Mittenfrequenz des Bandpaß-Filters im zweiten Transceiver, die gleich der negativen Mittenfrequenz des Bandpaß-Filters des ersten Transceivers ist.

Der erste und zweite Zeitabschnitt können die bei Zeitduplex-Verfahren üblichen Sende- bzw. Empfangenszeitschlitze bezeichnen. Das gleichzeitige Senden und Empfangen ist dabei ohne Berücksichtigung von Laufzeit- oder Ausbreitungseffekten beschrieben. Falls Laufzeit- oder Ausbreitungseffekte von Funksignalen oder leitungs- bzw. wellenleitergebundenen Signalen in signifikanter Weise auftreten, sind die Formulierungen "gleichzeitig" entsprechend zu verstehen. Beispielsweise wäre in diesem Fall der erste Zeitabschnitt für Empfangen um die Laufzeit bezüglich des Sende-Zeitabschnittes verschoben.

Ein Vorteil eines Zeitduplex-Verfahrens gegenüber einem Frequenzduplex-Verfahren kann der mögliche Verzicht auf ein Duplexfilter, beispielsweise an der Antenne, zum Auftrennen eines Sende- und eines Empfangszweiges im Transceiver sein. Diese Duplexfilter sind üblicherweise aufwendig zu realisierende SAW(surface acoustic wave, Oberflächenwellen)-Filter.

Die erste Trägerfrequenz und die zweite Trägerfrequenz unterscheiden sich um einen Betrag einer Frequenzabweichung. Beispielsweise kann die erste Trägerfrequenz die Mittenfrequenz eines ersten Kanals und die zweite Trägerfrequenz die Mittenfrequenz eines zweiten Kanals sein.

Der erste und der zweite Transceiver können eine Zweipunktverbindung bilden. Der erste Transceiver kann eine Basisstation sein und es können mehrere, zweite Transceiver vorhanden sein, welche jeweils Mobilstationen bilden. Der erste Transceiver kann in einer Master/Slave-Konfiguration ein Master sein und es können mehrere Slaves vom Typ des zweiten Transceivers vorhanden sein. Dabei sendet im ersten Zeitabschnitt der erste Transceiver und im zweiten Zeitabschnitt senden abwechselnd die Slaves. Dabei können mehrere, zweite Zeitabschnitte vorgesehen sein.

Gemäß einer Ausführungsform der vorliegenden Erfindung ist in den Empfangszweigen je ein Polyphasen-Receiver vorgesehen mit einem IQ-Mischer, dem ein Empfangssignal und das erste bzw. zweite Lokaloszillator-Signal eingangsseitig zuführbar sind und an dessen Ausgang ein komplexes Bandpaß-Filter angeschlossen ist, dessen Mittenfrequenz beim ersten Transceiver der positiven Zwischenfrequenz der Zwischenfrequenzebene und beim zweiten Transceiver der negativen Zwischenfrequenz der Zwischenfrequenzebene entspricht.

Die Vorzeichen der Zwischenfrequenzen sind vertauschbar. Die Lokaloszillator-Signale sind als komplexe Signale mit einer Inphase- und einer dazu 90° phasenverschobenen Quadratur-Komponente zuführbar.

In einer alternativen Ausführungsform der vorliegenden Erfindung ist in den Empfangszweigen je ein Image-Reject-Receiver gebildet mit einem IR-Mischer, dem ein Empfangssignal und das erste bzw. zweite Lokaloszillator-Signal eingangsseitig zuführbar sind und an dessen Ausgang ein Bandpaß-Filter angeschlossen ist, wobei im IR-Mischer des ersten Transceivers die um den Betrag der Frequenzabweichung verminderte erste Trägerfrequenz und in dem IR-Mischer des zweiten Transceivers die um den Betrag der Frequenzabweichung erhöhte erste Trägerfrequenz, welche gleich der zweiten Trägerfrequenz ist, unterdrückt wird.

In einer vorteilhaften Ausführungsform der vorliegenden Erfindung weisen erster und zweiter Transceiver im Sende- und Empfangszweig jeweils eine Zwischenfrequenzebene auf, welche sich voneinander um den Betrag der Frequenzabweichung unterscheiden. Sende- und Empfangszweig der Transceiver können als Heterodynsender und Heterodynempfänger ausgeführt sein. Diese haben jeweils zumindest eine Zwischenfrequenzebene. Aufgrund unterschiedlicher Zwischenfrequenzen müßten erster und zweiter Lokaloszillator jeweils zwischen Senden und Empfangen auf eine neue Frequenz einschwingen, was durch die beschriebene Anordnung mit erster und zweiter Trägerfrequenz vermieden wird. Dabei unterscheiden sich erste und zweite Trägerfrequenz gerade um den Betrag der Frequenzabweichung der Zwischenfrequenzebenen von Sende- und Empfangszweig voneinander.

In einer weiteren, vorteilhaften Ausführungsform der vorliegenden Erfindung weisen erster und zweiter Transceiver je einen als Homodynsender ausgebildeten Sendezweig und einen als Heterodynempfänger ausgebildeten Empfangszweig mit einer Zwischenfrequenzebene auf, welche für eine Zwischenfrequenz ausgelegt ist, deren Betrag gleich dem Betrag der Frequenzabweichung ist.

In einer besonders bevorzugten Ausgestaltung des Systems sind die Sendezweige der Transceiver jeweils als Homodynsender mit on-frequency Modulation oder direkter Hochfrequenz-Modulation der Sendefrequenz ausgeführt. Empfängerseitig hingegen ist eine heterodyne Architektur, beispielsweise low-IF, vorgesehen, wobei Hochfrequenzsignale mittels erster oder zweiter Trägerfrequenz zunächst in die Zwischenfrequenzebene und in einer weiteren Frequenzkonverter-Stufe ins Basisband heruntergemischt werden. Vorteilhafter Weise können die Empfangszweige dabei eine Empfangsstruktur mit niedriger Zwischenfrequenz, low IF, aufweisen, welche beispielsweise ein Megahertz betragen kann. Demnach ist die Differenz der Zwischenfrequenzebenen gerade die Frequenz der empfangsseitigen Zwischenfrequenz selbst. Dann gilt die Bedingung, daß der Betrag der Frequenzabweichung zwischen erster und zweiter Trägerfrequenz gerade gleich dem Betrag der Frequenz der Zwischenfrequenzebene ist. In diesem Fall wird im ersten Transceiver unter Benutzung der ersten Trägerfrequenz auf eine positive Zwischenfrequenz heruntergemischt, während im zweiten Transceiver mit der zweiten Trägerfrequenz auf die vorzugsweise betragsgleiche negative Zwischenfrequenz heruntergemischt wird, oder umgekehrt. Da sich die Trägerfrequenzen gerade um den Betrag der Frequenz der Zwischenfrequenzebene unterscheiden, müssen die Lokaloszillatoren der Transceiver zwischen Sende- und Empfangszeitabschitten nicht mehr neu einschwingen.

In einer weiteren, vorteilhaften Ausführungsform der vorliegenden Erfindung ist der Betrag der Frequenzabweichung ein ganzzahliges Vielfaches eines Kanalabstands von Sende- bzw. Empfangskanälen des Systems zur Datenübertragung.

In einer weiteren, vorteilhaften Ausführungsform der vorliegenden Erfindung ist der Betrag der Frequenzabweichung gleich dem Kanalabstand.

In einer weiteren, vorteilhaften Ausführungsform der Erfindung weist das System eine Master-Slave-Struktur auf, bei der ein erster Transceiver und mehrere zweite Transceiver vorgesehen sind.

Bezüglich des Verfahrens wird die Erfindung von einem Verfahren zur Datenübertragung, insbesondere für den Mobilfunk, gelöst, gekennzeichnet durch folgende Verfahrensschritte: Sendebetrieb eines ersten Transceivers in einem ersten Zeitabschnitt durch Abstimmen des ersten Transceivers auf einen ersten Kanal,
Empfangsbetrieb eines zweiten Transceivers in dem ersten Zeitabschnitt zum Empfang von vom ersten Transceiver gesendeten Signalen durch Abstimmen des zweiten Transceivers auf einen zweiten Kanal,
Sendebetrieb des zweiten Transceivers in einem zweiten Zeitabschnitt durch Abstimmen des zweiten Transceivers auf den zweiten Kanal und
Empfangsbetrieb des ersten Transceivers in dem zweiten Zeitabschnitt zum Empfang von vom zweiten Transceiver gesendeten Signalen durch Abstimmen des ersten Transceivers auf den ersten Kanal.

Das beschriebene Verfahren zur Datenübertragung bildet einen ersten Übertragungsweg während des ersten Zeitabschnittes, während dem der erste Transceiver sendet und der zweite Transceiver empfängt. Bei diesem ersten Übertragungsweg ist der Sender des ersten Transceivers auf einen ersten Kanal abgestimmt, der zweite Transceiver ist jedoch während des ersten Zeitabschnittes auf den zweiten Kanal abgestimmt. Bei umgekehrter Übertragungsrichtung, bei dem während des zweiten Zeitabschnittes der zweite Transceiver sendet und der erste Transceiver empfängt, ist der zweite Transceiver auf den zweiten Kanal abgestimmt und der erste Transceiver ist auf den ersten Kanal abgestimmt.

Da erster und zweiter Transceiver jeweils zwischen Senden und Empfangen nicht ihre Kanalabstimmung ändern, sondern jeweils mit der gleichen Kanalabstimmung senden und empfangen, müssen keine besonderen Anforderungen an die Schnelligkeit der verwendbaren Phasenregelkreise gestellt werden, sondern es sind Standard-PLL verwendbar. Dies wird dadurch erreicht, daß der erste Transceiver im Empfangsbetrieb auf einer positiven und der zweite Transceiver im Empfangsbetrieb auf negativer Zwischenfrequenz oder umgekehrt empfängt. Welcher Transceiver welches Zwischenfrequenz-Vorzeichen hat, hängt davon ab, ob der erste oder der zweite Kanal höhere Frequenzen hat.

In einer vorteilhaften Ausführungsform des Verfahrens erfolgen die Sendebetriebe des ersten und zweiten Transceivers durch direkte Modulation, on-frequency Modulation, und die Empfangsbetriebe des ersten und zweiten Transceivers erfolgen mit einer Zwischenfrequenzebene, d.h. mit heterodyner Struktur. Der Betrag der Frequenz der Zwischenfrequenzebene ist dabei gleich dem Betrag eines ganzzahligen Vielfaches der Differenz der Trägerfrequenz des ersten Kanals und der Träger- bzw. Mittenfrequenz des zweiten Kanals.

In einer weiteren, vorteilhaften Ausführungsform des Verfahrens ist der Betrag der Frequenz der Zwischenfrequenzebenen von erstem und zweitem Transceiver gleich dem Betrag der Differenz von der Mittenfrequenz des ersten Kanals und der Mittenfrequenz des zweiten Kanals, welche auch als Kanalabstand bezeichnet wird.

Weitere Einzelheiten der Erfindung sind in den Unteransprüchen angegeben.

Die Erfindung wird nachfolgend anhand von Ausführungsbeispielen an mehreren Zeichnungen erläutert. Es zeigen:
- Figur 1: eine prinzipielle Anordnung eines beispielhaften erfindungsgemäßen Systems zur Datenübertragung,
- Figuren 2a und 2b: die jeweiligen Trägerfrequenzen der Lokaloszillatoren gemäß Figur 1,
- Figuren 3a und 3b: die Kanalabstimmung bei einem System gemäß Figur 1,
- Figur 4: ein erstes Beispiel der Realisierung der Empfangszweig-Strukturen aus Figur 1 und
- Figur 5: ein zweites Beispiel der Realisierung der Empfangszweig-Architekturen gemäß Figur 1.

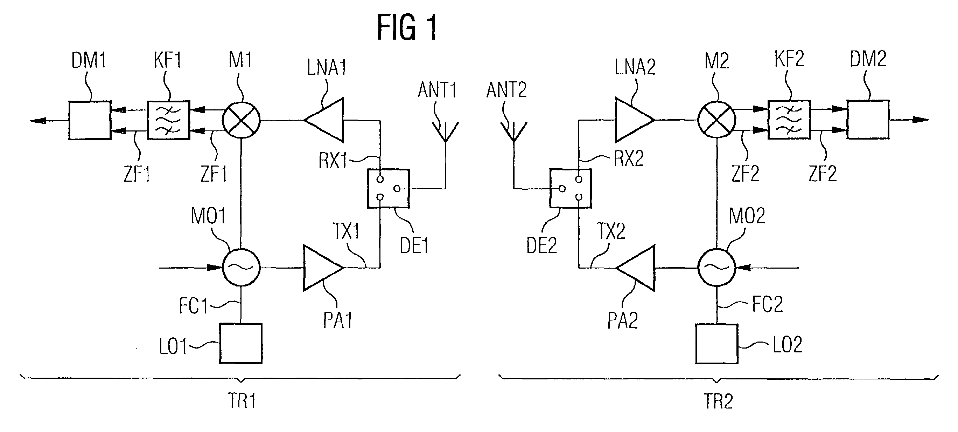

Figur 1 zeigt jeweils ein Blockschaltbild eines ersten Transceivers TR1 und eines zweiten Transceivers TR2. Die Transceiver TR1, TR2 weisen jeweils einen Sendezweig TX1, TX2 und einen Empfangszweig RX1, RX2 auf. Mit je einer Duplex-Einheit DE1, DE2 sind je ein Sende- und Empfangszweig TX1, RX1; TX2, RX2 an je eine Antenne ANT1, ANT2 angeschlossen. Die Duplex-Einheiten DE1, DE2 dienen dabei jeweils zum Umschalten zwischen Sende- und Empfangsbetrieb. Zur Signalverstärkung sind in den Sende- und Empfangszweigen TX1, TX2, RX1, RX2 jeweils Leistungsverstärker PA1, PA2 sowie rauscharme Vorverstärker LNA1, LNA2 vorgesehen. Zum Modulieren eines Sendesignals auf eine erste Trägerfrequenz FC1 weist der erste Transceiver TR1 einen Modulator MO1 auf, welcher eingangsseitig zur Zuführung der ersten Trägerfrequenz FC1 an einen ersten Lokaloszillator LO1 angeschlossen ist. Der erste Lokaloszillator LO1 ist weiterhin an einen ersten, im Empfangszweig RX1 vorgesehenen ersten Mischer M1 zum Heruntermischen eines Empfangssignals auf eine erste Zwischenfrequenzebene ZF1 angeschlossen. Dem ersten Mischer M1 ist dabei ein Kanalfilter KF1 und ein Demodulator DF1 nachgeschaltet. Analog zum ersten Transceiver TR1 ist beim zweiten Transceiver TR2 ein Lokaloszillator LO2 an einen Modulator MO2 im Sendezweig TX2 und an einem Mischer M2 im Empfangszweig RX2 zur Zuführung je einer Trägerfrequenz FC2 vorgesehen. Zu beachten ist bei dem System zur Datenübertragung gemäß Figur 1, daß erster und zweiter Transceiver TR1, TR2 je nur einen Lokaloszillator LO1, LO2 aufweisen, welcher sowohl zum Bereitstellen einer Trägerfrequenz FC1, FC2 in einem Sendebetrieb als auch zum Bereitstellen einer Trägerfrequenz FC1, FC2 in einem Empfangsbetrieb vorgesehen ist. Hierdurch können die Transceiver TR1, TR2 gemäß der Figur 1 zur Bildung eines Systems zur Datenübertragung in besonders einfacher Weise, mit geringem Chipflächenbedarf und geringem Strombedarf sowie kostengünstig hergestellt werden.

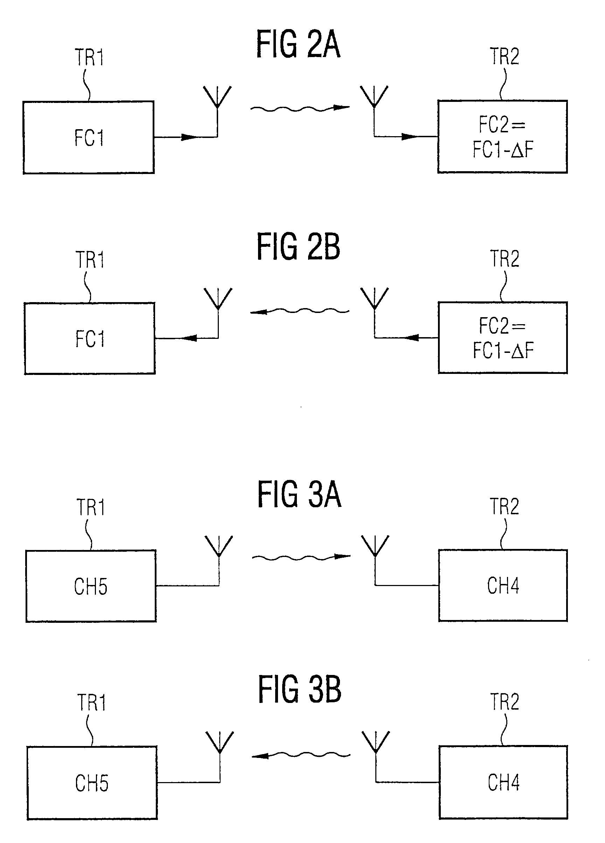

Zur Erläuterung des Sende- und Empfangsbetriebs bei einem System zur Datenübertragung gemäß Figur 1 sind in den Figuren 2a und 2b die jeweiligen, von den Lokaloszillatoren LO1, LO2 für Senden bzw. Empfangen zu erzeugenden Trägerfrequenzen FC1 FC2 schematisch dargestellt. In einer ersten Übertragungsrichtung, siehe Figur 2a, in einem Sendebetrieb des ersten Transceivers TR1 und einem Empfangsbetrieb des zweiten Transceivers TR2 während eines ersten Zeitabschnitts, erzeugt der erste Lokaloszillator LO1 die erste Trägerfrequenz FC1 für eine direkte Hochfrequenz-Modulation. Im zweiten Transceiver TR2 wird unter Benutzung der zweiten Trägerfrequenz FC2, welche vom zweiten Lokaloszillator LO2 bereitgestellt wird, das empfangene Hochfrequenzsignal auf eine zweite Zwischenfrequenz ZF2 heruntergemischt. Dabei ist die zweite Trägerfrequenz FC2 gegenüber der ersten Trägerfrequenz FC1 um einen Betrag einer Frequenzabweichung ΔF vermindert. In einer umgekehrten Übertragungsrichtung, d.h. bei einem Sendebetrieb des zweiten Transceivers TR2 und einem Empfangsbetrieb des ersten Transceivers TR1 während eines zweiten Zeitabschnittes ist, wie in Figur 2b gezeigt, der zweite Lokaloszillator LO2 auf die zweite Trägerfrequenz FC2 abgestimmt, und der erste Lokaloszillator LO1 auf die erste Trägerfrequenz FC1 abgestimmt. Hierdurch müssen bei einem Wechsel der Übertragungsrichtung, d.h. beim Umschalten von Senden nach Empfangen oder umgekehrt, im ersten und im zweiten Transceiver TR1, TR2 die Lokaloszillatoren LO1, LO2 nicht auf eine neue Trägerfrequenz bzw. Lokaloszillator-Frequenz einschwingen. Somit können Standard-PLL verwendet werden. In vorteilhafter Weise ist der Betrag der Frequenzabweichung ΔF, um den sich die Trägerfrequenzen FC1, FC2 unterscheiden, gleich dem Betrag der Frequenz der ersten und zweiten Zwischenfrequenzebene ZF1, ZF2 bei einer heterodynen Empfänger- und einer homodynen Senderarchitektur der Transceiver TR1, TR2 des Systems zur Datenübertragung. Hierdurch arbeitet der erste Transceiver TR1 bei einer positiven Zwischenfrequenz ZF1, der zweite Transceiver TR2 bei einer negativen Zwischenfrequenzebene, welche dem Betrage nach gleich der ersten Zwischenfrequenzebene des ersten Transceivers ist. Demnach empfängt der erste Transceiver TR1 ein oberes Seitenband und der zweite Transceiver TR2 ein unteres Seitenband des jeweils gesendeten Hochfrequenz-Signals.

Figuren 3a und 3b zeigen eine bevorzugte Ausführung des Systems und des Verfahrens zur Datenübertragung, bei dem der Kanalabstand gleich dem Betrag der Frequenzabweichung ΔF ist. Mehrere, benachbarte Sende- und Empfängskanäle CH4, CH5 weisen dabei jeweils den Kanalabstand auf, d.h. die Differenz der Mittenfrequenzen von erstem und zweiten Übertragungskanal CH4, CH5. Gemäß Figur 3a ist im Sendebetrieb der erste Transceiver TR1 mit seinem ersten Lokaloszillator LO1 auf den zweiten Kanal CH5 abgestimmt, während der zweite Lokaloszillator LO2 des zweiten Transceivers TR2 auf einen ersten Kanal CH4 abgestimmt ist. Figur 3b zeigt die umgekehrte Übertragungsrichtung, bei der der zweite Transceiver TR2, welcher auf den ersten Kanal CH4 abgestimmt ist, sendet und der erste Transceiver TR1, welcher auf dem zweiten Kanal CH5 abgestimmt ist, empfängt.

In alternativen Ausführungsformen des Systems und Verfahrens zur Datenübertragung kann der Betrag der Frequenzabweichung ΔF einem ganzzahligen Vielfachen des Kanalabstands der Übertragungskanäle voneinander bzw. der Differenzen ihrer Mittenfrequenzen entsprechen.

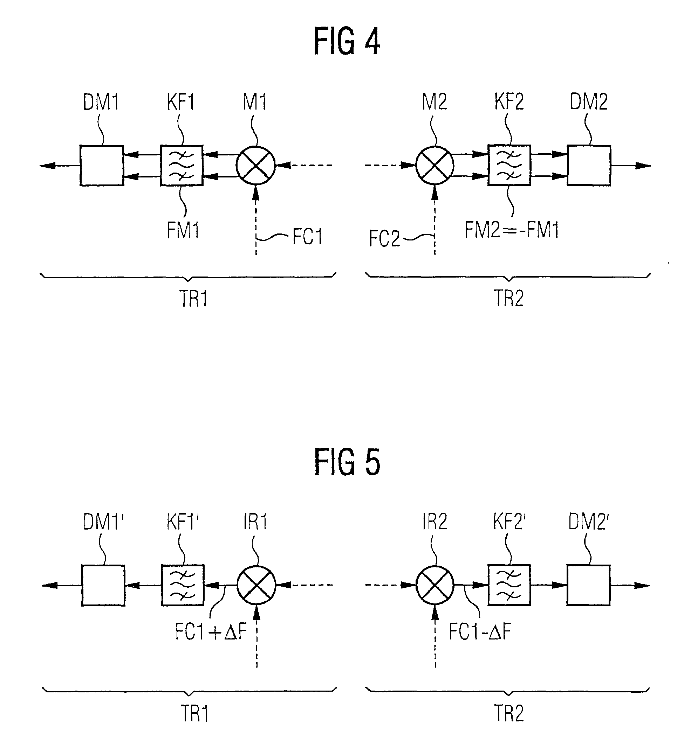

Figur 4 zeigt ein erstes Ausführungsbeispiel einer möglichen Empfangszweig-Architektur gemäß dem System zur Datenübertragung von Figur 1. Dabei sind erster und zweiter Mischer M1, M2 als IQ-Mischer ausgeführt, denen eingangsseitig ein Hochfrequenz-Empfangssignal zuführbar ist. Weiterhin ist den IQ-Mischern M1, M2 je ein Signal mit einer Trägerfrequenz FC1, FC2 zuführbar, welches als komplexes Signal zugeführt werden kann. Ausgangsseitig an die Mischer M1, M2 ist jeweils ein komplexes Bandpaß-Kanalfilter KF1, KF2 angeschlossen, wobei das erste Kanalfilter KF1 eine Mittenfrequenz FM1 hat, welche der negativen Frequenz der Zwischenfrequenzebene ZF1 entspricht und wobei das zweite, komplexe Kanalfilter KF2 eine zweite Mittenfrequenz FM2 hat, welche umgekehrtes Vorzeichen gegenüber der ersten Mittenfrequenz FM1 hat.

Eine beispielhafte, alternative Architektur der Empfangszweige der Transceiver TR1, TR2 ist in Figur 5 angegeben. Dort ist je ein Image-Reject-Mixer IR1, IR2 vorgesehen, der zugleich zum Mischprozeß eines Hochfrequenz-Eingangssignals herunter auf ein Zwischenfrequenzsignal das jeweils unerwünschte Frequenzband unterdrückt und beispielsweise im ersten Transceiver die Summe aus erster Trägerfrequenz und Betrag der Frequenzabweichung FC1 + ΔF durchläßt und die Differenz aus erster Trägerfrequenz FC1 und Betrag der Frequenzabweichung ΔF unterdrückt und der zweite Image-Reject-Mixer IR2 die Differenz von erster Trägerfrequenz FC1 und Betrag der Frequenzabweichung ΔF durchläßt und die Summe aus erster Trägerfrequenz FC1 und Betrag der Frequenzabweichung ΔF unterdrückt. Die Unterdrückung bzw. das Durchlassen vom oberen oder unteren Seitenband kann bei erstem und zweiten Transceiver TR1, TR2 auch vertauscht sein.

### Bezugszeichenliste

- TR1: erster Transceiver
- TR2: zweiter Transceiver
- TX1: Sendezweig
- TX2: Sendezweig
- RX1: Empfangszweig
- RX2: Empfangszweig
- LO1: erster Lokaloszillator
- LO2: zweiter Lokaloszillator
- ZF1: erste Zwischenfrequenzebene
- ZF2: zweite Zwischenfrequenzebene
- M1: Mischer
- M2: Mischer
- MO1: Modulator
- MO2: Modulator
- DM1: Demodulator
- DM2: Demodulator
- DM1': Demodulator
- DM2': Demodulator
- KF1: Kanalfilter
- KF2: Kanalfilter
- KF1': Kanalfilter
- KF2': Kanalfilter
- DE1: Duplex-Einheit
- DE2: Duplex-Einheit
- LNA1: rauscharmer Vorverstärker
- LNA2: rauscharmer Vorverstärker
- PA1: Leistungsverstärker
- PA2: Leistungsverstärker
- FC1: erste Trägerfrequenz
- FC2: zweite Trägerfrequenz
- FM1: erste Mittenfrequenz
- FM2: zweite Mittenfrequenz
- IR1: Image-Reject-Mixer
- IR2: Image-Reject-Mixer
- CH4: erster (Übertragungs-) Kanal
- CH5: zweiter (Übertragungs-)Kanal
- ΔF: Betrag einer Frequenzabweichung

## Patentansprüche

1. System zur Datenübertragung, insbesondere im Mobilfunk, mit
- einem ersten Transceiver (TR1) mit einem Sendezweig (TX1) zum Senden in einem ersten Zeitabschnitt und einem Empfangszweig (RX1) zum Empfangen in einem zweiten Zeitabschnitt,
- einem zweiten Transceiver (TR2) mit einem Sendezweig (TX2) zum Senden in dem zweiten Zeitabschnitt und einem Empfangszweig (RX2) zum Empfangen in dem ersten Zeitabschnitt,
- einem ersten Lokaloszillator (LO1) im ersten Transceiver (TR1), der an dessen Sendezweig (TX1) und an den Empfangszweig (RX1) zur Bereitstellung eines ersten Lokaloszillator-Signals mit einer ersten Trägerfrequenz (FC1) angeschlossen ist, wobei die erste Trägerfrequenz (FC1) für Senden und Empfangen gleich ist,
- einem zweiten Lokaloszillator (L02) im zweiten Transceiver (TR2), der an dessen Sende- und Empfangszweig (TX2, RX2) zur Bereitstellung eines zweiten Lokaloszillator-Signals mit einer zweiten Trägerfrequenz (FC2) angeschlossen ist, wobei die zweite Trägerfrequenz (FC2) für Senden und Empfangen gleich ist und sich von der ersten Trägerfrequenz (FC1) um einen Betrag einer Frequenzabweichung (ΔF) unterscheidet, wobei in den Empfangszweigen (RX1, RX2) je ein Polyphasen-Receiver vorgesehen ist mit je einem IQ-Mischer (M1, M2), dem ein Empfangssignal und das erste bzw. zweite Lokaloszillator-Signal eingangsseitig zuführbar sind und an dessen Ausgang je ein komplexes Bandpaß-Filter (KF1, KF2) angeschlossen ist, mit einer Mittenfrequenz (FM2) des Bandpaß-Filters (KF2) im zweiten Transceiver (TR2), die gleich der negativen Mittenfrequenz (FM1) des Bandpaß-Filters (KF1) des ersten Transceivers (TR1) ist.

2. System zur Datenübertragung, insbesondere für den Mobilfunk, mit
- einem ersten Transceiver (TR1) mit einem Sendezweig (TX1) zum Senden in einem ersten Zeitabschnitt und einem Empfangszweig (RX1) zum Empfangen in einem zweiten Zeitabschnitt,
- einem zweiten Transceiver (TR2) mit einem Sendezweig (TX2) zum Senden in dem zweiten Zeitabschnitt und einem Empfangszweig (RX2) zum Empfangen in dem ersten Zeitabschnitt,
- einem ersten Lokaloszillator (LO1) im ersten Transceiver (TR1), der an dessen Sendezweig (TX1) und an den Empfangszweig (RX1) zur Bereitstellung eines ersten Lokaloszillator-Signals mit einer ersten Trägerfrequenz (FC1) angeschlossen ist, wobei die erste Trägerfrequenz (FC1) für Senden und Empfangen gleich ist,
- einem zweiten Lokaloszillator (LO2) im zweiten Transceiver (TR2), der an dessen Sende- und Empfangszweig (TX2, RX2) zur Bereitstellung eines zweiten Lokaloszillator-Signals mit einer zweiten Trägerfrequenz (FC2) angeschlossen ist, wobei die zweite Trägerfrequenz (FC2) für Senden und Empfangen gleich ist und sich von der ersten Trägerfrequenz (FC1) um einen Betrag einer Frequenzabweichung (ΔF) unterscheidet, wobei in den Empfangszweigen (RX1, RX2) je ein Image-Reject-Receiver gebildet ist mit einem als Image-Reject-Mischer (IR1, IR2) ausgeführten Mischer, dem ein Empfangssignal und das erste bzw. zweite Lokaloszillator-Signal eingangsseitig zuführbar sind, wobei im Image-Reject-Mischer (IR1) des ersten Transceivers die um den Betrag der Frequenzabweichung (ΔF) verminderte erste Trägerfrequenz (FC1) und in dem zweiten Transceiver (TR2) die um den Betrag der Frequenzabweichung (ΔF) vergrößerte erste Trägerfrequenz (FC1) unterdrückt wird.

3. System zur Datenübertragung nach Anspruch 1 oder 2,
**dadurch gekennzeichnet, daß**
erster und zweiter Transceiver (TR1, TR2) im Sende- und Empfangszweig (TX1, RX1; TX2, RX2) jeweils eine Zwischenfrequenzebene aufweisen, wobei sich die Zwischenfrequenzebene des Sende-, von der Zwischenfrequenzebene des Empfangszweiges jeweils um den Betrag der Frequenzabweichung (ΔF) unterscheiden.

4. System zur Datenübertragung nach Anspruch 1 oder 2,
**dadurch gekennzeichnet, daß**
erster und zweiter Transceiver (TR1, TR2) je einen als Homodynsender ausgebildeten Sendezweig (TX1, TX2) und einen als Heterodynempfänger ausgebildeten Empfangszweig (RX1, RX2) mit einer Zwischenfrequenzebene (ZF1, ZF2) aufweisen, welche für eine Zwischenfrequenz ausgelegt ist, deren Betrag gleich dem Betrag der Frequenzabweichung (ΔF) ist.

5. System zur Datenübertragung nach einem der Ansprüche 1 bis 4,
**dadurch gekennzeichnet, daß**
der Betrag der Frequenzabweichung (ΔF) ein ganzzahliges Vielfaches eines Kanalabstands von Sende- und Empfangskanälen (CH4, CH5) des Systems zur Datenübertragung ist.

6. System zur Datenübertragung nach Anspruch 5,
**dadurch gekennzeichnet, daß**
der Betrag der Frequenzabweichung (ΔF) gleich dem Kanalabstand ist.

7. System zur Datenübertragung nach einem der Ansprüche 1 bis 6,
**dadurch gekennzeichnet, daß**
das System eine Master-Slave-Struktur aufweist, bei der ein erster Transceiver und mehrere zweite Transceiver vorgesehen sind.

8. Verfahren zur Datenübertragung, insbesondere für den Mobilfunk, **gekennzeichnet durch** folgende Verfahrensschritte:
- Abstimmen eines ersten Transceivers (TR1) auf einen ersten Kanal (CH4) und Senden von Signalen mit dem ersten Transceiver (TR1) in einem ersten Zeitabschnitt,
- Abstimmen eines zweiten Transceivers (TR2) auf einen zweiten Kanal (CH5) und Empfangen von vom ersten Transceiver (TR1) gesendeten Signalen mit dem zweiten Transceiver (TR2) in dem ersten Zeitabschnitt,
- Abstimmen des zweiten Transceivers (TR2) auf den zweiten Kanal (CH5) und Senden von Signalen mit dem zweiten Transceiver (TR2) in einem zweiten Zeitabschnitt und
- Abstimmen des ersten Transceivers (TR1) auf den ersten Kanal (CH4) und Empfangen von vom zweiten Transceiver (TR2) gesendeten Signalen mit dem ersten Transceiver (TR1) in dem zweiten Zeitabschnitt.

9. Verfahren zur Datenübertragung nach Anspruch 8,
**dadurch gekennzeichnet, daß**
erster und zweiter Transceivers (TR1, TR2) in direkter Modulation senden und unter Benutzung einer Zwischenfrequenzebene (ZF1, ZF2) empfangen, wobei der Betrag der Zwischenfrequenz der Zwischenfrequenzebenen (ZF1, ZF2) gleich einem ganzzahligen Vielfachen der Differenz der Mittenfrequenzen von erstem und zweitem Kanal (CH4, CH5) ist.

10. Verfahren zur Datenübertragung nach Anspruch 9,
**dadurch gekennzeichnet, daß**
der Betrag der Zwischenfrequenz von erster und zweiter Zwischenfrequenzebene (ZF1, ZF2) gleich der Differenz der Mittenfrequenzen von erstem und zweitem Übertragungskanal (CH4, CH5) ist.
